# EUROPEAN PATENT APPLICATION

(11) **EP 4 475 178 A1**
(43) Date of publication of application: **11.12.2024**
(21) Application number: 23746805.3
(22) Date of filing: 19.01.2023
(51) Int. Cl.: H01L 23/12, H05K 3/34

(54) **WIRING BOARD**

(30) Priority: 31.01.2022 JP 2022012537
(71) Applicant: Kyocera Corporation, Kyoto-shi Kyoto 612-8501 (JP)
(72) Inventor: HAYANO, Kazuki, Kyoto-shi, Kyoto 612-8501 (JP)
(74) Representative: Viering, Jentschura & Partner mbB Patent- und Rechtsanwälte
(86) International application number: PCT/JP2023/001462
(87) International publication number: WO 2023/145592

(57) **Abstract**

A wiring board according to the present disclosure includes an insulation layer including a first surface and a second surface located on an opposite side to the first surface, and a pad located on the first surface. The first surface includes a first region including a plane along the second surface, and a second region located around the first region and including an inclined surface inclined from the first region toward the second surface. A surface of the second region includes a plurality of recessed portions and protruding portions, and an arithmetic average roughness of the surface of the second region is greater than an arithmetic average roughness of a surface of the first region. A central portion of the pad is located in the first region, and a peripheral edge portion of the pad is located in the second region.

## Description

### TECHNICAL FIELD

The present disclosure relates to a wiring board.

### BACKGROUND OF INVENTION

As disclosed in Patent Document 1, a wiring board is provided with a connection terminal (pad) for electrical connection to a semiconductor element or the like. As disclosed in Patent Document 1, the pad is formed of a plurality of metal layers. In such a pad, a contact surface with an insulation layer is likely to be peeled off, and connection reliability may be poor.

### CITATION LIST

### PATENT LITERATURE

Patent Document 1: JP 2015-216344 A

### SUMMARY

### SOLUTION TO PROBLEM

A wiring board according to the present disclosure includes an insulation layer including a first surface and a second surface located on an opposite side to the first surface, and a pad located on the first surface. The first surface includes a first region including a plane along the second surface, and a second region located around the first region and including an inclined surface inclined from the first region toward the second surface. A surface of the second region includes a plurality of recessed portions and protruding portions, and an arithmetic average roughness of the surface of the second region is greater than an arithmetic average roughness of a surface of the first region. A central portion of the pad is located in the first region, and a peripheral edge portion of the pad is located in the second region.

### BRIEF DESCRIPTION OF THE DRAWINGS

FIG. 1 is an explanatory view for illustrating an example of a pad included in a wiring board according to one embodiment of the present disclosure.
FIG. 2 is an electron micrograph of showing one example of a region X illustrated in FIG. 1.
FIG. 3 is an explanatory view for illustrating a process of forming the pad included in the wiring board according to one embodiment of the present disclosure.
FIG. 4 is an explanatory view for illustrating another example of the pad included in the wiring board according to one embodiment of the present disclosure.

### DESCRIPTION OF EMBODIMENTS

In the pad formed of a plurality of metal layers as described above, the contact surface with the insulation layer is likely to be peeled off, and the connection reliability may become poor. For this reason, there is a need for a wiring board in which peeling between the insulation layer and the pad is reduced and connection reliability is excellent.

As described above, a wiring board according to the present disclosure includes a second region including an inclined surface inclined from a first region toward a second surface, a surface of the second region includes a plurality of recessed portions and protruding portions, and the arithmetic average roughness of the surface of the second region is greater than the arithmetic average roughness of a surface of the first region. As a result, according to the wiring board of the present disclosure, peeling between the insulation layer and the pad can be reduced, and excellent connection reliability can be exhibited.

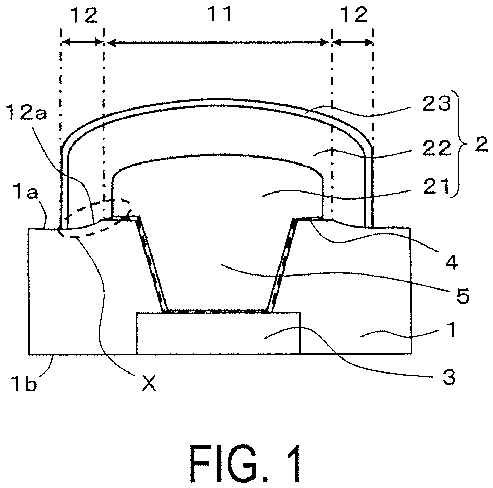

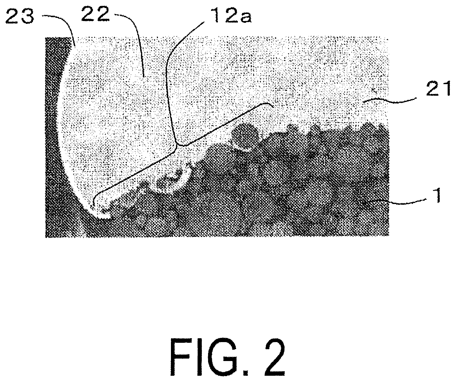

A wiring board according to one embodiment of the present disclosure will be described with reference to FIGs. 1 and 2. FIG. 1 is an explanatory view for illustrating an example of a pad included in a wiring board according to one embodiment of the present disclosure. FIG. 2 is an electron micrograph showing one example of a region X illustrated in FIG. 1. Although not specifically illustrated, the wiring board according to one embodiment has a structure in which at least one insulation layer 1 and at least one conductor layer 3 are alternately stacked. FIG. 1 illustrates a vicinity of a pad 2 formed on the insulation layer 1 located at the outermost layer of the wiring board.

The insulation layer 1 is, specifically, a core insulation layer and a build-up insulation layer. The insulation layer 1 is formed of a resin such as an epoxy resin, a bismaleimide-triazine resin, a polyimide resin, a polyphenylene ether resin, or a liquid crystal polymer. These resins may be used alone or in a combination of two or more. As illustrated in FIG. 2, insulation particles may be dispersed in the insulation layer 1. In FIG. 2, the circular shapes are the insulation particles. The insulation particles are not limited, and examples thereof may include inorganic insulation fillers made of silica, alumina, barium sulfate, talc, clay, glass, calcium carbonate, and titanium oxide. When two or more insulation layers 1 are present, the insulation layers may be formed of the same resin or may be formed of different resins.

When the insulation layer 1 is a core insulation layer, the core insulation layer has a thickness of, for example, 0.04 mm or greater and 3.0 mm or less. The core insulation layer includes a through hole conductor for electrically connecting the conductor layers 3 on upper and lower surfaces of the core insulation layer. The through hole conductor is located in a through hole penetrating through the upper and lower surfaces of the core insulation layer. The through hole conductor is formed of a conductor made of metal plating such as copper plating, for example. The through hole conductor is connected to the conductor layers 3 on both the surfaces of the core insulation layer. The through hole conductor may be formed only on an inner wall surface of the through hole, or the through hole may be filled with the through hole conductor.

When the insulation layer 1 is a build-up insulation layer, the build-up insulation layer has a thickness of, for example, 2 µm or greater and 200 µm or less. The build-up insulation layers may be formed of the same resin or may be formed of different resins. The build-up insulation layer includes a via-hole conductor 5 for electrically connecting the conductor layers 3 located above and below the build-up insulation layer. The via-hole conductor 5 is obtained by depositing, for example, copper plating or the like, in a via-hole penetrating through upper and lower surfaces of the build-up insulation layer. As illustrated in FIG. 1, the via-hole conductor 5 may be located filling the via-hole, or the via-hole conductor 5 may be adhered to an inner surface of the via-hole and a portion of the via-hole where the via-hole conductor 5 is not provided may be filled with a resin.

The conductor layer 3 is located on a main surface of the insulation layer 1, that is, on each of a main surface of the core insulation layer and a main surface of the build-up insulation layer. The conductor layer 3 is formed of copper such as a copper foil or copper plating. The thickness of the conductor layer 3 is not particularly limited, and falls, for example, within a range of 2 µm or greater and 70 µm or less.

As illustrated in FIG. 1, a pad 2 is located on the insulation layer 1 located at the outermost layer of the wiring board. Specifically, the pad 2 is located on a first surface 1a of main surfaces (a first surface 1a and a second surface 1b located on an opposite side to the first surface 1a) of the insulation layer 1 located at the outermost layer. As illustrated in FIG. 1, the pad 2 is connected to the conductor layer 3 through the via-hole conductor 5.

The first surface 1a includes a first region 11 and a second region 12. The first region 11 is a region including a plane along the second surface 1b. The second region 12 is a region located around the first region 11 and including an inclined surface 12a inclined from the first region 11 toward the second surface 1b.

A surface of the second region 12 has a plurality of recessed portions and protruding portions, and an arithmetic average roughness of the surface of the second region 12 is greater than an arithmetic average roughness of a surface of the first region 11. A gap (height difference) between a bottom of the recessed portion and a top of the protruding portion is about 0.2 µm or greater and 0.4 µm or less. With such a structure, the wiring board according to one embodiment can reduce peeling between the insulation layer 1 and the pad 2.

The arithmetic average roughness of the surface of the second region 12 may be, for example, 0.05 µm or greater and 0.5 µm or less in that the peeling between the insulation layer 1 and the pad 2 can be further reduced. The arithmetic average roughness of the surface of the second region 12 may be greater than the arithmetic average roughness of the surface of the first region 11 by about 0.03 µm or greater and 0.4 µm or less. The width of the second region 12 is not limited and may be, for example, 1 µm or greater and 5 µm or less. When the width of the second region 12 is 3.5 µm or greater and 4.5 µm or less, it is particularly advantageous from a standpoint of ensuring adhesion between the pad 2 and the insulation layer 1.

In the wiring board according to one embodiment, a central portion of the pad 2 is located in the first region 11, and a peripheral edge portion of the pad 2 is located in the second region 12. That is, the peripheral edge portion of the pad 2 that is likely to be peeled off is located in the second region 12 having a relatively high arithmetic average roughness. As a result, as illustrated in FIG. 2, an anchor effect is likely to be exhibited at the peripheral edge portion of the pad 2, and as described above, the peeling between the insulation layer 1 and the pad 2 can be reduced.

The structure of the pad 2 is not limited and may be, for example, a three-layered structure as illustrated in FIG. 1. That is, as illustrated in FIG. 1, the pad 2 includes a first metal portion 21, a second metal portion 22, and a third metal portion 23.

The first metal portion 21 is formed of a first metal and is located in the first region 11. The first metal portion 21 is located at a central portion of the pad 2. Examples of the first metal may include a copper plating and a copper foil. The thickness of the first metal portion 21 (the height from the first region 11) is not limited, and may be, for example, 2 µm or greater and 70 µm or less. As illustrated in FIG. 1, the via-hole conductor 5 is located in the first region 11 and connected to the first metal portion 21.

The second metal portion 22 is formed of a second metal and is located so as to cover the first metal portion 21. At least a part of the second metal portion 22 is located in the second region 12. In other words, at least a part of the second metal portion 22 is in contact with the insulation layer 1 in the second region 12. The second metal is preferably metal that is less likely to form a compound than the first metal due to heat generated when solder is welded to the pad 2, for example. Examples of the second metal may include nickel. The thickness of the second metal portion 22 is not limited as long as the second metal portion can cover the first metal portion 21, and may be, for example, 1 µm or greater and 6 µm or less.

As illustrated in FIG. 2, a part of the second metal portion 22 may be located in the recessed portion of the second region 12. With such a configuration, a stronger anchor effect is exhibited, and the peeling between the insulation layer 1 and the pad 2 can be further reduced.

The third metal portion 23 is formed of a third metal and is located so as to cover the second metal portion 22. The third metal portion 23 is located in the second region 12. In other words, the third metal portion 23 is in contact with the insulation layer 1 in the second region 12. The third metal is preferably a metal having solder wettability superior to that of the second metal. The improved solder wettability improves the connection reliability between a solder and an electrode of a semiconductor element when the semiconductor element is mounted. Examples of the third metal may include gold and palladium. The thickness of the third metal portion 23 is not limited as long as the third metal portion can cover the second metal portion 22, and may be, for example, 0.05 µm or greater and 0.15 µm or less.

In consideration of the simplicity of the manufacturing process, the cost, the solder wettability, and the like, it is preferable that the first metal forming the first metal portion 21 contain copper, the second metal forming the second metal portion 22 contain nickel, and the third metal forming the third metal portion 23 contain gold.

In the wiring board according to one embodiment, an underlying metal layer 4 may be located at least between the first metal portion 21 and the insulation layer 1. Examples of the underlying metal layer 4 include nickel, chromium, and an alloy of nickel and chromium (nichrome). In addition to this, transition metals of Group 4, Group 5, or Group 6 of the periodic table such as titanium, chromium, nickel, tantalum, molybdenum, tungsten, and palladium may be formed using sputtering or vapor deposition other than sputtering. Among these metals, the underlying metal layer 4 preferably contains nickel and chromium, such as nichrome.

In the wiring board according to one embodiment, although not illustrated, a palladium layer may be located between the second metal portion 22 and the third metal portion 23. When the palladium layer is located between the second metal portion 22 and the third metal portion 23, it is possible to reduce an intermetallic compound generated between the second metal portion 22 and the third metal portion 23 due to heat. The thickness of the palladium layer is not limited, and may be, for example, 0.02 µm or greater and 0.10 µm or less.

As described above, the wiring board according to one embodiment includes the second region 12 including the inclined surface 12a inclined from the first region 11 toward the second surface 1b, the surface of the second region 12 has the plurality of recessed portions and protruding portions, and the arithmetic average roughness of the surface of the second region 12 is greater than the arithmetic average roughness of the surface of the first region 11. As a result, according to the wiring board of one embodiment, it is possible to reduce the peeling between the insulation layer 1 and the pad 2 in the peripheral edge portion of the pad 2 where the peeling is likely to occur, and to exhibit excellent connection reliability.

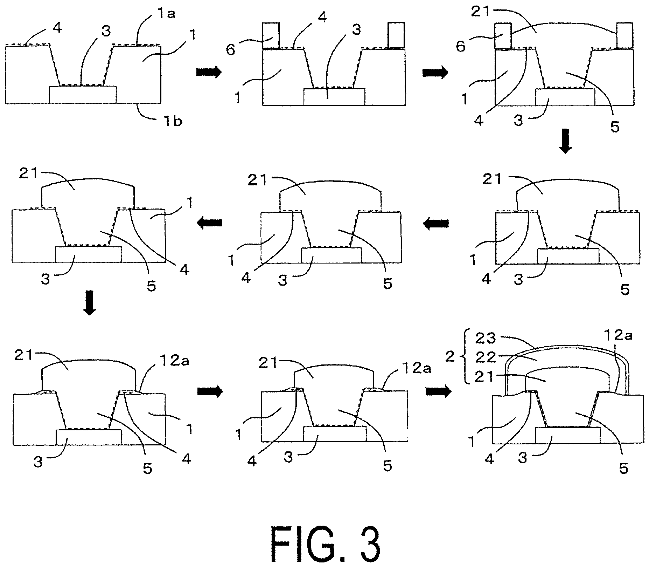

In the wiring board 2 according to one embodiment, the method of forming the pad 2 is not limited, and the pad is formed by, for example, a process as illustrated in FIG. 3. FIG. 3 is an explanatory view for illustrating a process of forming the pad 2 included in the wiring board according to one embodiment of the present disclosure.

First, a via-hole having an opening on a first surface 1a side is formed in an insulation layer 1 located at the uppermost layer of the wiring board. The via-hole is formed by a laser machining process such as one using a CO₂ laser, a UV-YAG laser or an excimer laser. A conductor layer 3 is exposed on a bottom surface (second surface 1b side) of the via-hole. If necessary, an underlying metal layer 4 is formed on the first surface 1a of the insulation layer 1 and an inner peripheral surface and a bottom surface of the via-hole. The underlying metal layer 4 is as described above, and detailed description thereof will be omitted. A thinner copper layer may be formed on a surface of the underlying metal layer 4, as a part of the underlying metal layer 4.

Next, a dry film resist 6 is formed in the vicinity of an opening of the via-hole so as to surround the opening. The dry film resist 6 is formed of, for example, a polymer, an acrylic compound, or the like. The thickness (height) of the dry film resist 6 may be appropriately set in accordance with a desired thickness (height) of a pad 2 (first metal portion 21). The thickness (height) of the first metal portion 21 is as described above, and detailed description thereof will be omitted.

Then, a metal is deposited from the via-hole to a portion surrounded by the dry film resist 6 by electrolytic plating. The metal may be copper or the like, as described above. The metal deposited in the via-hole corresponds to the via-hole conductor 5, and the metal (first metal) deposited in a portion other than the via-hole corresponds to the first metal portion 21.

Then, the dry film resist 6 is removed. A method of removing the dry film resist 6 is not limited. The dry film resist 6 is removed, for example, by a resist remover such as a sodium hydroxide solution.

Then, after the dry film resist 6 is removed, the underlying metal layer 4 (including the thin copper layer) exposed on the first surface 1a of the insulation layer 1 is removed. The method of removing these layers is not limited, and examples thereof may include an etching treatment such as flash etching.

Then, a part of an outer peripheral surface of the deposited first metal portion 21 is removed by etching. At this time, an etching solution that dissolves the first metal portion 21 but does not dissolve the underlying metal layer 4 is used.

Then, the exposed portion of the underlying metal layer 4 is subjected to wet blasting, sand blasting, plasma treatment, or the like to remove the exposed underlying metal layer 4. At this time, the insulation layer 1 in the vicinity of the underlying metal layer 4 is also partially removed together with the exposed underlying metal layer 4 to form an inclined surface 12a.

Accordingly, a surface of a second region 12 including the inclined surface 12a has a plurality of recessed portions and protruding portions, and the arithmetic average roughness of the surface of the second region 12 is greater than the arithmetic average roughness of the surface of the first region 11. The arithmetic average roughness of the surface of the second region 12 and the width of the second region 12 are as described above, and detailed description thereof will be omitted.

Then, in order to remove an oxide film (copper oxide when the first metal portion 21 is formed of copper) formed on the outer peripheral surface of the first metal portion 21, an etching treatment is performed. In the etching treatment, an etching solution that dissolves the first metal portion 21 but does not dissolve the underlying metal layer 4 is used. By this etching treatment, a part of the underlying metal layer 4 is exposed around the first metal portion 21.

Then, a second metal portion 22 and a third metal portion 23 are formed. Specifically, the second metal portion 22 is formed by depositing the second metal by plating so as to cover the first metal portion 21. An example of the second metal is nickel, as described above. A part of the second metal is also deposited in the recessed portions of the second region 12. The thickness of the second metal portion 22 is as described above, and detailed description thereof will be omitted.

After the second metal portion 22 is formed, the third metal portion 23 is formed by depositing the third metal by plating so as to cover the second metal portion 22. An example of the third metal is nickel, as described above. The thickness of the third metal portion 23 is as described above, and detailed description thereof will be omitted. If necessary, a palladium layer may be formed so as to cover the second metal portion 22 before forming the third metal portion 23.

With the procedure described above, the pad 2 is formed on the wiring board according to one embodiment. Such a pad 2 is particularly employed, for example, as a pad in a High Bandwidth Memory (HBM) connection region.

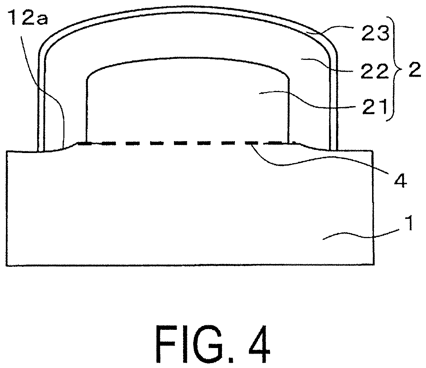

In the wiring board according to the present disclosure, the pad 2 is not limited to one connected to the via-hole conductor 5 as illustrated in FIG. 1. For example, as illustrated in FIG. 4, the pad 2 need not be connected to the via-hole conductor 5. FIG. 4 is an explanatory view for illustrating another example of the pad 2, and the same members as those illustrated in FIG. 1 are denoted by the same reference signs.

### REFERENCE SIGNS

1 Insulation layer
1a First surface
1b Second surface
11 First region
12 Second region
12a Inclined surface
2 Pad
21 First metal portion
22 Second metal portion
23 Third metal portion
3 Conductor layer
4 Underlying metal layer
5 Via-hole conductor
6 Dry film resist

## Claims

1. A wiring board comprising:
an insulation layer comprising a first surface and a second surface located on an opposite side to the first surface; and
a pad located on the first surface, wherein
the first surface comprises a first region comprising a plane along the second surface, and a second region located around the first region and comprising an inclined surface inclined from the first region toward the second surface,
a surface of the second region comprises a plurality of recessed portions and protruding portions, and an arithmetic average roughness of the surface of the second region is greater than an arithmetic average roughness of a surface of the first region, and
a central portion of the pad is located in the first region, and a peripheral edge portion of the pad is located in the second region.

2. The wiring board according to claim 1, wherein
the pad comprises a first metal portion made of a first metal, a second metal portion covering the first metal portion and made of a second metal, and a third metal portion covering the second metal portion and made of a third metal, and
the first metal portion is located in the first region, and the third metal portion and at least a part of the second metal portion are located in the second region.

3. The wiring board according to claim 2, wherein
a part of the second metal portion is located in the recessed portions of the second region.

4. The wiring board according to claim 2 or 3, wherein
a via-hole conductor is located in the first region of the insulation layer, and the via-hole conductor is connected to the first metal portion.

5. The wiring board according to any one of claims 2 to 4, wherein
an underlying metal layer is located at least between the first metal portion and the insulation layer.

6. The wiring board according to any one of claims 2 to 5, wherein
the first metal contains copper, the second metal contains nickel, and the third metal contains gold.

7. The wiring board according to claim 5 or 6, wherein
the underlying metal layer contains nickel and chromium.

8. The wiring board according to any one of claims 2 to 7, further comprising:
a palladium layer located between the second metal portion and the third metal portion.

9. The wiring board according to any one of claims 1 to 8, wherein
the arithmetic average roughness of the surface of the second region is 0.05 µm or greater and 0.5 µm or less.

10. The wiring board according to any one of claims 1 to 9, wherein
a width of the second region is 1 µm or greater and 5 µm or less.
